# EUROPÄISCHE PATENTSCHRIFT

(11) **EP 3 248 215 B1**
(45) Veröffentlichungstag und Bekanntmachung des Hinweises auf die Patenterteilung: **26.12.2018**
(21) Anmeldenummer: 15787593.1
(22) Anmeldetag: 29.10.2015
(51) Int. Cl.: H01L 21/322

(54) **EPITAKTISCH BESCHICHTETE HALBLEITERSCHEIBE UND VERFAHREN ZUR HERSTELLUNG EINER EPITAKISCH BESCHICHTETEN HALBLEITERSCHEIBE**
EPITAXIALLY COATED SEMICONDUCTOR WAFER, AND METHOD FOR PRODUCING AN EPITAXIALLY COATED SEMICONDUCTOR WAFER
TRANCHE SEMI-CONDUCTRICE REVÊTUE PAR ÉPITAXIE ET PROCÉDÉ DE FABRICATION D'UNE TRANCHE SEMI-CONDUCTRICE REVÊTUE PAR ÉPITAXIE

(30) Priorität: 21.01.2015 DE 102015200890
(43) Veröffentlichungstag der Anmeldung: 29.11.2017
(73) Patentinhaber: Siltronic AG, 81737 München (DE)
(72) Erfinder: MÜLLER, Timo, 84489 Burghausen (DE); GEHMLICH, Michael, 09600 Weissenborn (DE); FALLER, Frank, 84524 Neuötting (DE)
(74) Vertreter: Staudacher, Wolfgang
(86) Internationale Anmeldenummer: PCT/EP2015/075189
(87) Internationale Veröffentlichungsnummer: WO 2016/116180

(56) Entgegenhaltungen:
- EP-A1- 1 345 262
- DE-A1-102012 214 085
- JP-A- 2003 077 924
- JP-A- 2009 170 940

## Beschreibung

Gegenstand der Erfindung ist eine epitaktisch beschichtete Halbleiterscheibe umfassend eine Substratscheibe aus einkristallinem Silizium, eine polierte epitaktische Schicht aus Silizium auf der Vorderseite der Substratscheibe, eine denuded zone, die sich von der polierten epitaktischen Schicht in die Substratscheibe erstreckt und ein Bereich, der an die denuded zone angrenzt und BMD-Keime aufweist. Gegenstand der Erfindung ist auch ein Verfahren zur Herstellung einer epitaktisch beschichteten Halbleiterscheibe.

Eine denuded zone ist ein oberflächennaher Bereich der epitaktisch beschichteten Halbleiterscheibe, in dem BMDs (bulk micro defects) genannte Sauerstoffpräzipitate nicht gebildet werden. Dieser Bereich erstreckt sich von der oberen Seitenfläche ins Innere (bulk) der epitaktisch beschichteten Halbleiterscheibe. Üblicherweise ist die denuded zone als Ort vorgesehen, um elektronische Bauelemente zu beherbergen.

An die denuded zone grenzt ein weiter ins Innere (bulk) der Halbleiterscheibe reichender Bereich an, in dem BMD-Keime vorhanden sind. BMD-Keime werden durch eine Wärmebehandlung zu BMDs entwickelt. BMDs wirken als Zentren eines internen Getters, der insbesondere metallische Verunreinigungen binden kann. Die Entwicklung von BMD-Keimen zu BMDs ist auch im Zug einer Wärmebehandlung möglich, die vornehmlich dem Aufbau von elektronischen Bauelementen in der denuded zone dient.

Ein Trend verfolgt das Ziel, eine möglichst hohe Dichte an BMDs möglichst nahe an die denuded zone angrenzend zur Verfügung zu stellen. Ein weiterer Trend verfolgt das Ziel, die Tiefe der denuded zone auf das Maß zu beschränken, das für die Unterbringung von elektronischen Bauelementen notwendig ist.

Es ist bekannt, dass kurzzeitiges schnelles Aufheizen und Abkühlen der Halbleiterscheibe in einer nitridierend wirkenden Atmosphäre Leerstellen injiziert und dass die Gegenwart von Leerstellen die Nukleation von BMD-Keimen im Inneren der Halbleiterscheibe unterstützt. Eine Wärmebehandlung durch kurzzeitiges schnelles Aufheizen und Abkühlen wird auch RTA-Behandlung (rapid thermal anneal) genannt.
In der US 2002/0127766 A1 ist ein Verfahren zur Herstellung einer Halbleiterscheibe aus einkristallinem Silizium mit polierter epitaktischer Schicht, einer denuded zone und einem Bereich mit BMD-Keimen beschrieben. Das Verfahren umfasst eine RTA-Behandlung nach dem Abscheiden einer epitaktischen Schicht.
Eine RTA-Behandlung stellt, insbesondere angewendet auf epitaktisch beschichtete Halbleiterscheiben, eine thermische Belastung dar, mit der das Problem verbunden ist, Vergleitungen (slip) im Kristallgitter zu verursachen. Darüber hinaus erhöht eine RTA-Behandlung auch die Rauheit der Oberfläche der epitaktischen Schicht. Typischerweise steigt die durch AFM (atomic force microscope) bestimmte RMS-Rauheit an, und es wird eine vergleichsweise hohe Anzahl an Streulichtzentren nachgewiesen, die LLS-Defekte (localized light scatterers) genannt werden, wobei die Dichte dieser Defekte im Randbereich der Oberfläche der epitaktischen Schicht besonders hoch ist.
In der US2002/0022351 A1 wird vorgeschlagen, die Oberfläche der Substratscheibe vor dem Abscheiden der epitaktischen Schicht in Gegenwart von Chlorwasserstoff-Gas und einer Silan-Quelle zu glätten. Dieses Verfahren hat jedoch keinen Einfluss auf Vorgänge, die nach dem Abscheiden der epitaktischen Schicht die Rauheit von deren Oberfläche beeinträchtigen.

JP 2009 170940 A (SUMCO CORP) 30. Juli 2009 (2009-07-30) offenbart ein Verfahren zur Herstellung einer epitaktisch beschichteten Halbleiterscheibe, umfassend das Bereitstellen einer Substratscheibe aus einkristallinem Silizium mit einer Vorderseite und mit einer Rückseite; das Abscheiden einer epitaktischen Schicht aus Silizium auf der Vorderseite der Substratscheibe; das Behandeln der epitaktischen Schicht mit einem Oxidationsmittel; eine RTA-Behandlung der epitaktisch beschichteten Halbleiterscheibe bei einer Temperatur in einem Temperaturbereich von nicht weniger als 1160 °C und nicht mehr als 1185 °C für einen Zeitraum von nicht weniger als 15 s und nicht mehr als 30 s, wobei die epitaktische Schicht einer Atmosphäre bestehend aus Argon und Ammoniak ausgesetzt wird und sich eine Oxynitrid-Schicht auf der epitaktischen Schicht bildet; das Entfernen der Oxynitrid-Schicht.

Es ist deshalb die Aufgabe der vorliegenden Erfindung, ein verbessertes Verfahren bereitzustellen, das eine epitaktisch beschichtete Halbleiterscheibe aus Silizium mit besonderen Eigenschaften, die denuded zone und BMD-Keime sowie die Rauheit der Oberfläche der epitaktischen Schicht betreffend, zur Verfügung stellt.

Gelöst wird die Aufgabe durch eine epitaktisch beschichtete Halbleiterscheibe, umfassend
eine Substratscheibe aus einkristallinem Silizium mit einer Vorderseite und mit einer Rückseite;
eine epitaktische Schicht aus Silizium mit polierter Oberfläche auf der Vorderseite der Substratscheibe, wobei die polierte Oberfläche eine RMS-Rauheit von nicht mehr als 0,055 nm bezogen auf ein Messfenster mit einer Fläche von 10 µm x 10 µm aufweist;
eine denuded zone, die sich von der polierten Oberfläche der epitaktischen Schicht zur Rückseite der Substratscheibe bis zu einer Tiefe erstreckt, die zwischen einem Zentrum und einem Rand der Halbleiterscheibe nicht weniger als 6 µm und nicht mehr als 14 µm beträgt, und
eine Region, die an die denuded zone angrenzt und BMD-Keime aufweist, die sich zu BMDs mit einer Spitzendichte von nicht weniger als 3,5 x 10⁹ cm⁻³ in einem Abstand von nicht mehr als 70 µm zur polierten Oberfläche der epitaktischen Schicht entwickeln lassen.

Der Unterschied der durch AFM in einem Messfenster mit der Fläche 10 µm x 10 µm bestimmten RMS-Rauheit zwischen einem Zentrumsgebiet der Oberfläche und einem Randgebiet der Oberfläche der epitaktischen Schicht beträgt vorzugsweise nicht mehr als 5 % bezogen auf die Rauheit im Zentrumsgebiet.

Die Entwicklung der BMD-Keime zu BMDs erfolgt beispielsweise durch eine zweistufige Präzipitations-Wärmebehandlung der epitaktisch beschichteten Halbleiterscheibe bei Temperaturen von 750 bis 850 °C für eine Dauer von 1 bis 4 h (1.Stufe) und Temperaturen von 950 bis 1050 °C für eine Dauer von 8 bis 20 h (2.Stufe). Die Entwicklung der BMD-Keime zu BMDs kann aber auch durch eine vergleichbare Wärmebehandlung der epitaktisch beschichteten Halbleiterscheibe bewirkt werden, die hauptsächlich zum Zweck des Aufbaus von elektronischen Bauelementen vorgenommen wird.

Die Substratscheibe hat vorzugsweise einen Durchmesser von mindestens 300 mm und besteht vorzugsweise aus dotiertem einkristallinem Silizium. Der Dotierstoff ist vom n-Typ, beispielsweise Phosphor, oder vom p-Typ, beispielsweise Bor. Der Grad der Dotierung ist im Fall einer Dotierung vom n-Typ vorzugsweise n⁻, im Fall einer Dotierung vom p-Typ vorzugsweise p⁺, entsprechend einem spezifischen Widerstand im Bereich von 5 bis 80 Ωcm im Fall der Dotierung vom n-Typ und von 5 bis 20 mΩcm, vorzugsweise 10 bis 20 mΩcm im Fall der Dotierung vom p-Typ.

Eine epitaktisch abgeschiedene und polierte Schicht aus einkristallinem Silizium bedeckt die Vorderseite der Substratscheibe. Die Vorderseite ist eine obere Seitenfläche der Substratscheibe, die Rückseite eine untere Seitenfläche der Substratscheibe. Die epitaktisch abgeschiedene Schicht ist vorzugsweise ebenfalls dotiert, besonders bevorzugt derart, dass es sich um eine n/n⁻ oder um eine p/p⁺ epitaktisch beschichtete Halbleiterscheibe handelt. In unpoliertem Zustand hat die epitaktisch abgeschiedene Schicht vorzugsweise eine Dicke von nicht weniger als 1 µm und nicht mehr als 12 µm.

Wegen der nachfolgend beschriebenen Verfahrensführung zur Herstellung der epitaktisch beschichteten Halbleiterscheibe ist die Verteilung der BMD-Keime beziehungsweise der entwickelten BMDs in Dickenrichtung der Halbleiterscheibe nicht symmetrisch.

Die denuded zone hat eine Tiefe von nicht weniger als 6 µm und nicht mehr als 14 µm. Dann steigt die Dichte der BMD-Keime beziehungsweise entwickelter BMDs bis zu einer Spitzendichte mit hoher Steigerungsrate an und fällt weniger steil auf ein Niveau ab, das bis zur Rückseite der Substratscheibe nahezu unverändert bleibt. Nach einer Entwicklung der BMD-Keime zu BMDs beträgt die Spitzendichte an BMDs auf einem Radius zwischen dem Zentrum und dem Rand der Halbleiterscheibe nicht weniger als 3,5 x 10⁹ cm⁻³ und hat einen Abstand zur polierten Oberfläche der epitaktischen Schicht von nicht mehr als 70 µm. Nach einer Entwicklung der BMD-Keime zu BMDs beträgt die Dichte an BMDs im Abstand von 50 µm zur polierten Oberfläche der epitaktischen Schicht vorzugsweise nicht weniger als 70 % der Spitzendichte. Die Dichte entwickelter BMDs ist im Abstand von 200 µm zur polierten Oberfläche der epitaktischen Schicht bis zur Rückseite der Substratscheibe vorzugsweise nicht größer als 60 % der Spitzendichte.

Gegenstand der Erfindung ist auch ein Verfahren zur Herstellung einer epitaktisch beschichteten Halbleiterscheibe, umfassend das Bereitstellen einer Substratscheibe aus einkristallinem Silizium mit einer Vorderseite und mit einer Rückseite;
das Abscheiden einer epitaktischen Schicht aus Silizium auf der Vorderseite der Substratscheibe;
das Behandeln der epitaktischen Schicht mit einem Oxidationsmittel;
eine RTA-Behandlung der epitaktisch beschichteten Halbleiterscheibe bei einer Temperatur in einem Temperaturbereich von nicht weniger als 1160 °C und nicht mehr als 1185 °C für einen Zeitraum von nicht weniger als 15 s und nicht mehr als 30 s, wobei die epitaktische Schicht einer Atmosphäre bestehend aus Argon und Ammoniak ausgesetzt wird und sich eine Oxynitrid-Schicht auf der epitaktischen Schicht bildet;
das Entfernen der Oxynitrid-Schicht; und
das Polieren der epitaktischen Schicht.

Als Quelle für die benötigten Substratscheiben kommen insbesondere Einkristalle aus Silizium in Frage, die gemäß der CZ-Methode gezogen wurden. Bei dieser Methode wird Silizium in einem Tiegel aus Quarz geschmolzen und der Einkristall wächst am Ende eines Keimkristalls, der in die entstandene Schmelze getaucht und angehoben wird. Das Tiegelmaterial wird von der Schmelze teilweise gelöst und stellt auf diese Weise Sauerstoff zur Verfügung, der später zur Entwicklung von BMDs benötigt wird.

Die Substratscheibe wird zusammen mit einer Vielzahl weiterer Substratscheiben vom Einkristall geschnitten und mechanischen, chemischen und chemisch-mechanischen Bearbeitungsschritten unterworfen, vorzugsweise um eine Substratscheibe zu erhalten, deren Vorderseite und Rückseite möglichst eben sind und parallel zueinander liegen. Besonders bevorzugt ist eine Substratscheibe mit einer Vorderseite und einer Rückseite, wobei zumindest die Vorderseite in poliertem Zustand vorliegt, und mit einer Kante zwischen der Vorderseite und der Rückseite, die ebenfalls poliert ist.

Die Substratscheibe enthält interstitiellen Sauerstoff mit einer Konzentration von vorzugsweise nicht weniger als 4,5 x 10¹⁷ Atome/cm³ und vorzugsweise nicht mehr als 7,0 x 10¹⁷ Atome/cm³ bei Anwendung des Kalibrierungsfaktors gemäß New ASTM. Die Elemente Kohlenstoff und Stickstoff können in der Substratscheibe vorhanden sein, vorzugsweise jedoch nicht in einer Konzentration, die üblicherweise nur durch absichtliches Hinzufügen solcher Elemente zu erreichen ist. Dementsprechend beträgt die Konzentration an Kohlenstoff vorzugsweise nicht mehr als 8,0 x 10¹⁵ Atome/cm³ und die Konzentration an Stickstoff vorzugsweise nicht mehr als 1,0 x 10¹² Atome/cm³. Das absichtliche Hinzufügen der genannten Elemente würde zwar die Bildung von BMD-Keimen erleichtern, sollte aber nicht erfolgen, um die Möglichkeit der Bildung von Stapelfehlern (OSF-Defekten) zu beschränken und um die elektrischen Eigenschaften der Substratscheibe nicht zu beeinträchtigen.

Die polierte Vorderseite der Substratscheibe wird epitaktisch beschichtet, vorzugsweise mittels CVD (chemical vapor deposition) und vorzugsweise in einem Einzelscheiben-Reaktor. Die Beschichtung der Substratscheibe im Einzelscheiben-Reaktor kann auf eine bekannte Art und Weise erfolgen, beispielsweise so, wie es in US 2010/0213168 A1 beschrieben ist. Ein bevorzugtes Abscheidegas enthält Trichlorsilan als Siliziumquelle. Die Abscheidetemperatur ist dann vorzugsweise nicht weniger als 1110 °C und nicht mehr als 1180 °C, besonders bevorzugt 1130 °C. Darüber hinaus enthält das Abscheidegas vorzugsweise einen Dotierstoff vom n-Typ oder p-Typ. Die Dicke der abgeschiedenen epitaktischen Schicht beträgt vorzugsweise nicht weniger als 1 µm und nicht mehr als 12 µm. Ergebnis dieses Verfahrensschritts ist eine epitaktisch beschichtete Halbleiterscheibe aus einkristallinem Silizium.

Zur Vorbereitung der RTA-Behandlung wird diese Halbleiterscheibe vorzugsweise gereinigt und die epitaktisch abgeschiedene Schicht mit einem Oxidationsmittel behandelt, das die frei liegende Oberfläche der epitaktischen Schicht oxidiert. Die Dicke der entstehenden Oxidschicht ist größer als die Dicke eines nativen Oxids. Bevorzugt wird eine RCA-Reinigung durchgeführt, umfassend die Behandlung der Halbleiterscheibe zunächst mit SC-1 Reinigungslösung enthaltend Ammoniumhydroxid, Wasserstoffperoxid und Wasser und anschließend mit SC-2 Reinigungslösung enthaltend Chlorwasserstoff, Wasserstoffperoxid und Wasser. Die darauf folgende oxidierende Behandlung der epitaktisch abgeschiedenen Schicht erfolgt vorzugsweise mit Ozon als Oxidationsmittel.

Die sich an die Oxidation anschließende RTA-Behandlung der epitaktisch beschichteten Halbleiterscheibe umfasst deren schnelles Erhitzen auf eine Temperatur in einem Temperaturbereich von nicht weniger als 1160 °C und nicht mehr als 1185 °C, vorzugsweise auf eine Temperatur von 1170 °C, und das Halten der epitaktisch beschichteten Halbleiterscheibe auf dieser Temperatur für einen Zeitraum von nicht weniger als 15 s und nicht mehr als 30 s. Die epitaktisch beschichtete Halbleiterscheibe wird von einer Starttemperatur, die vorzugsweise im Bereich von 550 °C bis 650 °C liegt, mit einer Temperatur-Steigerungsrate erhitzt, die vorzugsweise nicht weniger als 20 °C/s und nicht mehr als 100 °C/s ist. Besonders bevorzugt ist eine Temperatur-Steigerungsrate im Bereich von 35 bis 75 °C/s.

Die Temperatur der RTA-Behandlung sollte möglichst niedrig sein, um das Auftreten von Vergleitungen zu vermeiden. Die RTA-Behandlung wird deshalb derart ausgeführt, dass die mit dem Oxidationsmittel behandelte epitaktische Schicht einer Atmosphäre ausgesetzt ist, die aus einem Gemisch von Argon und Ammoniak besteht. Das Verhältnis von Argon:Ammoniak ist vorzugsweise 10:1 bis 24:1, besonders bevorzugt 20:1. In dieser Atmosphäre kann die beabsichtigte Injektion von Leerstellen bei einer niedrigeren Temperatur ausgelöst werden, als in einer Atmosphäre von Stickstoff.

Um die Belastung der epitaktisch beschichteten Halbleiterscheibe durch die RTA-Behandlung gering zu halten, ist es bevorzugt, die Rückseite der epitaktisch beschichteten Halbleiterscheibe und damit die Rückseite der Substratscheibe während der RTA-Behandlung einer Atmosphäre auszusetzen, die bei der Temperatur der RTA-Behandlung nicht oder kaum nitridierend wirkt. Eine geeignete Atmosphäre besteht vorzugsweise aus Stickstoff. Diese Maßnahme reduziert zusätzlich das Risiko des Entstehens von Vergleitungen.

Am Ende der RTA-Behandlung wird die epitaktisch beschichtete Halbleiterscheibe schnell abgekühlt, vorzugsweise auf eine Temperatur von nicht mehr als 500 °C. Hierfür genügt es, die Strahlungsheizung der RTA-Vorrichtung auszuschalten.

In Folge der RTA-Behandlung der epitaktisch beschichteten Halbleiterscheibe in der Atmosphäre bestehend aus Argon und Ammoniak bildet sich aus der Oxidschicht auf der epitaktischen Schicht eine Schicht, die Silizium-Oxynitrid enthält und nachfolgend Oxynitrid-Schicht genannt wird. Die Oxynitrid-Schicht wird entfernt, vorzugsweise durch Ätzen. Als Ätzmittel wird vorzugsweise ein wässeriges Ätzmittel verwendet, das nicht weniger als 0,8 % und nicht mehr als 2,0 % Fluorwasserstoff enthält. Das Entfernen der Oxynitrid-Schicht mittels Politur ist nicht vorgesehen, weil damit die Rauheit der Vorderseite erhöht und Partikel generiert würden.

Die epitaktisch abgeschiedene Schicht wird erst nach dem Entfernen der Oxynitrid-Schicht poliert. Bevorzugt ist eine Spiegelpolitur mit einem Materialabtrag von nicht weniger als 0,05 µm und nicht mehr als 0,2 µm. Nach der Spiegelpolitur wird die epitaktisch beschichtete Halbleiterscheibe zweckmäßigerweise endgereinigt.

Es ist darüber hinaus bevorzugt, nach dem Entfernen der Oxynitrid-Schicht und vor der Spiegelpolitur die epitaktisch beschichtete Halbleiterscheibe zunächst zu reinigen und anschließend mit einem Oxidationsmittel, vorzugsweise mit Ozon zu behandeln. Besonders bevorzugt ist wieder eine RCA-Reinigung umfassend die Behandlung der Halbleiterscheibe zunächst mit SC-1 Reinigungslösung und anschließend mit SC-2 Reinigungslösung.

Die Erfindung wird nachfolgend an Hand von Beispielen und unter Bezugnahme auf Zeichnungen weiter erläutert.

Es wurden beidseitig polierte Substratscheiben aus einkristallinem Silizium mit einem Durchmesser von 300 mm bereitgestellt. Substratscheiben gemäß Beispiel B1 enthielten interstitiellen Sauerstoff in einer Konzentration von 6,1 x 10¹⁷ bis 6,7 x 10¹⁷ Atome/cm³ (New ASTM) und waren p-Typ dotiert mit einem spezifischen Widerstand von 18 bis 19,5 mΩcm. Substratscheiben gemäß Beispiel B2 enthielten interstitiellen Sauerstoff in einer Konzentration von 5,3 x 10¹⁷ bis 5,6 x 10¹⁷ Atome/cm³ (New ASTM) und waren n-Typ dotiert mit einem spezifischen Widerstand von 29 bis 30 Ωcm. Die Substratscheiben wurden unter Anwendung einer erfindungsgemäßen Sequenz von Verfahrensschritten zu Halbleiterscheiben mit polierter epitaktischer Schicht verarbeitet. Die epitaktisch abgeschiedene Schicht hatte eine Dicke von 4 µm (Beispiel B1) beziehungsweise 9 µm (Beispiel B2). Die Halbleiterscheiben gemäß Beispiel B1 waren p/p⁺ epitaktisch beschichtete Halbleiterscheiben, diejenigen gemäß Beispiel B2 waren n/n⁻ epitaktisch beschichtete Halbleiterscheiben. Die epitaktisch abgeschiedenen Schichten hatten einen spezifischen Widerstand im Bereich von 29 bis 30 Ωcm.

Die Temperatur der RTA-Behandlung lag im Falle aller Halbleiterscheiben bei 1175 °C, die Dauer der RTA-Behandlung bei dieser Temperatur 15 s und 25 s (Beispiel B1) beziehungsweise 15 s, 25 s und 30 s (Beispiel B2). Alle Halbleiterscheiben wurden mit einer Temperatur-Steigerungsrate von 75 °C/s auf die Temperatur von 1175 °C erhitzt, und die epitaktisch abgeschiedene Schicht bei dieser Temperatur in einer Atmosphäre von Argon und Ammoniak im Verhältnis von 20:1 behandelt. Danach wurden die Halbleiterscheiben mit einer Temperatur-Senkungsrate von 35 °C/s abgekühlt.

Nach der RTA-Behandlung wurden die Halbleiterscheiben erfindungsgemäß zu Halbleiterscheiben mit polierter epitaktischer Schicht weiterverarbeitet und anschließend einer Wärmebehandlung zur Entwicklung von BMDs unterzogen. Diese Wärmebehandlung wurde unter Stickstoff durchgeführt und umfasste das Erhitzen der Halbleiterscheiben zunächst auf eine Temperatur von 800 °C über einen Zeitraum von 3 h und anschließend auf eine Temperatur von 1000 °C über einen Zeitraum von 16 h. Der BMD-Nachweis erfolgte mittels Laserlichtstreuung an einer Bruchkante mit einem Nachweisgerät vom Typ MO441 der Raytex Corporation.

In der nachfolgenden Tabelle 1 sind Daten bezüglich der ermittelten Tiefen der denuded zone und der ermittelten Dichten an BMDs eingetragen. Es bedeuten: "HZ" die Dauer der RTA-Behandlung bei der Temperatur der RTA-Behandlung;
"DZ1 av." die über den Radius der Halbleitescheibe gemittelte Tiefe der denuded zone;
"BMD av." die über den Radius der Halbleiterscheibe gemittelte Dichte an BMDs;
"BMD peak" die im Zentrum der Halbleiterscheibe ermittelte Spitzendichte an BMDs; und
"BMD 50pm" die in einer Tiefe von 50 µm im radialen Zentrum der Halbleiterscheibe gefundene Dichte an BMDs.

**Tabelle 1:**

| B1 | | | | | | | | | |
|---|---|---|---|---|---|---|---|---|---|
| HZ [s] | 15 | 15 | 15 | 25 | 25 | 25 | | | |
| DZ1 av. [µm] | 8,4 | 8,6 | 7,7 | 6,3 | 7,4 | 7,1 | | | |
| BMD av. [10⁹cm⁻³] | 3,87 | 3,9 | 5,36 | 5,77 | 5,3 | 5,94 | | | |
| BMD peak [10⁹cm⁻³] | 6,77 | 6,77 | 7,93 | 8, 67 | 8,65 | 8,05 | | | |
| BMD 50 µm [10⁹cm⁻³] | 6,08 | 6,02 | 8,23 | 8,02 | 8,77 | 8,4 | | | |

| B2 | | | | | | | | | |
|---|---|---|---|---|---|---|---|---|---|
| HZ [s] | 15 | 15 | 15 | 25 | 25 | 25 | 30 | 30 | 30 |
| DZ1 av. [µm] | 12 | 13,5 | 12,1 | 9,2 | 9,4 | 10,7 | 9, 6 | 9,3 | 8,8 |
| BMD av. [10⁹cm⁻³] | 4,11 | 3,24 | 3,20 | 5,71 | 4, 68 | 4,92 | 5,97 | 5,76 | 6,33 |
| BMD peak [10⁹cm⁻³] | 6,52 | 5,60 | 5,62 | 8,30 | 7,73 | 8,48 | 8,85 | 8, 63 | 8,97 |
| BMD 50 µm [10⁹cm⁻³] | 4,68 | 3,68 | 4,03 | 7,28 | 6,42 | 7,02 | 8,57 | 7,80 | 7, 68 |

Die Daten zu "DZ av." der Tabelle 1 zeigen, dass die Tiefe der denuded zone mit ansteigender Dauer der RTA-Behandlung abnimmt, und die Daten zu "BMD 50 µm" zeigen, dass der Unterschied zur Spitzendichte in der Tiefe von 50 µm mit ansteigender Dauer der RTA-Behandlung immer geringer wird. Die Tiefe der denuded zone entspricht nahezu in allen Fällen mindestens der Dicke der epitaktischen Schicht.

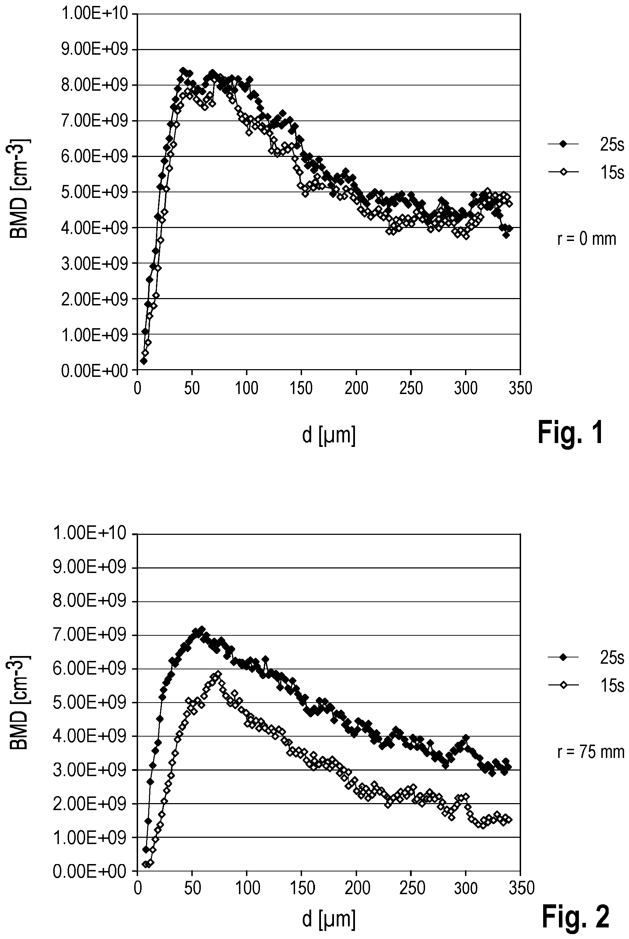

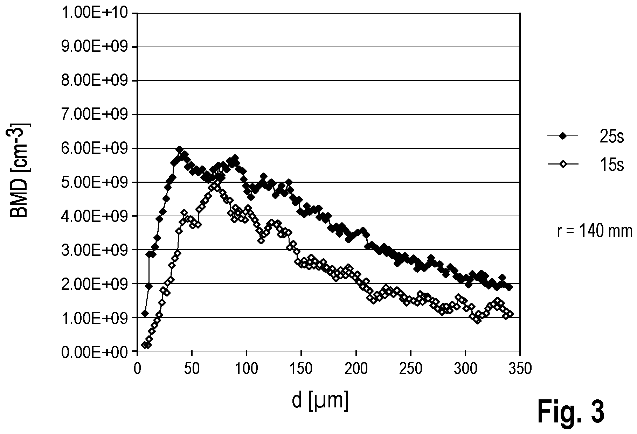

Fig.1 bis Fig.3 zeigen stellvertretend das Tiefenprofil an BMDs für eine Halbleiterscheibe gemäß Beispiel B1 im radialen Zentrum (r=0 mm), bei Radius r=75 mm und bei Radius r=140 mm.

**Tabelle 2**

| Entfernen der Oxynitrid -Schicht | RMS (r=0 mm) [nm] | RMS (r=75 mm) [nm] | RMS (r=140 mm) [nm] | σ[nm] | σ[%] |
|---|---|---|---|---|---|
| nein | 0,0525 | 0,057 | 0,0784 | 0.01129 | 18.04 |
| nein | 0,0518 | 0,0493 | 0,0626 | 0.00577 | 10.58 |
| ja | 0,0507 | 0,0497 | 0,0521 | 0.00098 | 1.94 |
| ja | 0,0483 | 0,0498 | 0,0495 | 0.00064 | 1.32 |
| ja | 0,0492 | 0,0484 | 0,0494 | 0.00043 | 0.88 |

Tabelle 2 enthält Werte zur RMS-Rauheit bezogen auf ein Messfenster mit einer Fläche von 10 µm x 10 µm. Die Daten zeigen, dass die RMS-Rauheit insbesondere im Randbereich der epitaktisch beschichteten Halbleiterscheibe verbessert ist, wenn die Oxynitrid-Schicht erfindungsgemäß entfernt wird. Die Standardabweichung σ beträgt nicht mehr als 5 %.

Das erfindungsgemäße Entfernen der Oxynitrid-Schicht ist auch besonders vorteilhaft hinsichtlich der Anzahl von LLS-Defekten, die nach dem Polieren der epitaktischen Schicht auf der polierten Oberfläche gefunden werden. Tabelle 3 enthält Angaben zur Anzahl an Streulichtzentren einer Größe von 120 nm und größer, die vor der RTA-Behandlung und nach der Spiegelpolitur auf der Oberfläche der epitaktischen Schicht zweier epitaktisch beschichteten Halbleiterscheiben gefunden wurden. Eine der Halbleiterscheiben war erfindungsgemäß hergestellt worden, die andere auf nahezu gleiche Weise, jedoch ohne das Entfernen der Oxynitrid-Schicht.

**Tabelle 3**

| Entfernen der Oxynitrid-Schicht | LLS-Defekte vor RTA-Behandlung [Anzahl] | LLS-Defekte nach Spiegelpolitur [Anzahl] |
|---|---|---|
| nein | 6 | 4098 |
| ja | 3 | 3 |

## Patentansprüche

1. Epitaktisch beschichtete Halbleiterscheibe, umfassend
eine Substratscheibe aus einkristallinem Silizium mit einer Vorderseite und mit einer Rückseite;
eine epitaktische Schicht aus Silizium mit polierter Oberfläche auf der Vorderseite der Substratscheibe, wobei die polierte Oberfläche eine RMS-Rauheit von nicht mehr als 0,055 nm bezogen auf ein Messfenster mit einer Fläche von 10 µm x 10 µm aufweist;
eine denuded zone, die sich von der polierten Oberfläche der epitaktischen Schicht zur Rückseite der Substratscheibe bis zu einer Tiefe erstreckt, die zwischen einem Zentrum und einem Rand der Halbleiterscheibe nicht weniger als 6 µm und nicht mehr als 14 µm beträgt, und
eine Region, die an die denuded zone angrenzt und BMD-Keime aufweist, die sich zu BMDs mit einer Spitzendichte von nicht weniger als 3,5 x 10⁹ cm⁻³ in einem Abstand von nicht mehr als 70 µm zur polierten Oberfläche der epitaktischen Schicht entwickeln lassen, und die BMD-Keime aufweist, die sich zu BMDs entwickeln lassen, deren Dichte im Abstand von 200 µm zur polierten Oberfläche der epitaktischen Schicht bis zur Rückseite der Substratscheibe nicht größer ist als 60 % der Spitzendichte.

2. Epitaktisch beschichtete Halbleiterscheibe nach Anspruch 1, die BMD-Keime aufweist, die sich zu BMDs entwickeln lassen, deren Dichte im Abstand von 50 µm zur polierten Oberfläche der epitaktischen Schicht nicht weniger als 70 % der Spitzendichte ist.

3. Verfahren zur Herstellung einer epitaktisch beschichteten Halbleiterscheibe, umfassend
das Bereitstellen einer Substratscheibe aus einkristallinem Silizium mit einer Vorderseite und mit einer Rückseite;
das Abscheiden einer epitaktischen Schicht aus Silizium auf der Vorderseite der Substratscheibe;
das Behandeln der epitaktischen Schicht mit einem Oxidationsmittel;
eine RTA-Behandlung der epitaktisch beschichteten Halbleiterscheibe bei einer Temperatur in einem Temperaturbereich von nicht weniger als 1160 °C und nicht mehr als 1185 °C für einen Zeitraum von nicht weniger als 15 s und nicht mehr als 30 s, wobei die epitaktische Schicht einer Atmosphäre bestehend aus Argon und Ammoniak ausgesetzt wird und sich eine Oxynitrid-Schicht auf der epitaktischen Schicht bildet, wobei die Rückseite der Substratscheibe während der RTA-Behandlung einer Atmosphäre ausgesetzt wird, die bei der Temperatur der RTA-Behandlung nicht oder kaum nitridierend wirkt;
das Entfernen der Oxynitrid-Schicht; und
das Polieren der epitaktischen Schicht.

4. Verfahren nach Anspruch 3, **dadurch gekennzeichnet, dass** die Oxynitrid-Schicht mit einem wässerigen Ätzmittel entfernt wird, das nicht weniger als 0,8 % und nicht mehr als 2,0 % Fluorwasserstoff enthält.

## Claims

1. Epitaxially coated semiconductor wafer, comprising a substrate wafer composed of monocrystalline silicon having a front side and having a rear side;
an epitaxial layer composed of silicon having a polished surface on the front side of the substrate wafer, wherein the polished surface has an RMS roughness of not more than 0.055 nm relative to a measurement window having an area of 10 µm × 10 µm;
a denuded zone extending from the polished surface of the epitaxial layer to the rear side of the substrate wafer as far as a depth which, between a center and an edge of the semiconductor wafer, is not less than 6 µm and not more than 14 µm, and
a region adjoining the denuded zone and having BMD nuclei which can develop into BMDs having a peak density of not less than 3.5 × 10⁹ cm⁻³ at a distance of not more than 70 µm from the polished surface of the epitaxial layer, and which has BMD nuclei which can develop into BMDs whose density at a distance of 200 µm from the polished surface of the epitaxial layer as far as the rear side of the substrate wafer is not greater than 60% of the peak density.

2. Epitaxially coated semiconductor wafer according to Claim 1, which has BMD nuclei which can develop into BMDs whose density at a distance of 50 µm from the polished surface of the epitaxial layer is not less than 70% of the peak density.

3. Method for producing an epitaxially coated semiconductor wafer, comprising
providing a substrate wafer composed of monocrystalline silicon, having a front side and having a rear side; depositing an epitaxial layer composed of silicon on the front side of the substrate wafer;
treating the epitaxial layer with an oxidant;
an RTA treatment of the epitaxially coated semiconductor wafer at a temperature in a temperature range of not less than 1160°C and not more than 1185°C for a time period of not less than 15 s and not more than 30 s, wherein the epitaxial layer is exposed to an atmosphere consisting of argon and ammonia and an oxynitride layer forms on the epitaxial layer, wherein the rear side of the substrate wafer, during the RTA treatment, is exposed to an atmosphere which has no or hardly any nitriding effect at the temperature of the RTA treatment;
removing the oxynitride layer; and
polishing the epitaxial layer.

4. Method according to Claim 3, **characterized in that** the oxynitride layer is removed using an aqueous etchant containing not less than 0.8% and not more than 2.0% hydrogen fluoride.

## Revendications

1. Galette en semiconducteur à revêtement épitaxial, comprenant
une galette de substrat en silicium monocristallin ayant un côté avant et ayant un côté arrière ;
une couche épitaxiale en silicium ayant une surface polie sur le côté avant de la galette de substrat, la surface polie possédant une rugosité RMS maximale de 0,055 nm rapportée à une fenêtre de mesure ayant une superficie de 10 µm x 10 µm ;
une zone dépouillée qui s'étend de la surface polie de la couche épitaxiale au côté arrière de la galette de substrat jusqu'à une profondeur qui, entre un centre et un bord de la galette en semiconducteur, n'est pas inférieure à 6 µm et pas supérieure à 14 µm, et
une région qui est adjacente à la zone dépouillée et possède des germes de BMD, lesquels peuvent se développer en BMD ayant une densité de pointe non inférieure à 3,5 x 10⁹ cm⁻³ à une distance maximale de 70 µm de la surface polie de la couche épitaxiale, et qui possède des germes de BMD, lesquels peuvent se développer en BMD dont la densité à une distance de 200 µm de la surface polie de la couche épitaxiale jusqu'au côté arrière de la galette de substrat n'est pas supérieure à 60 % de la densité de pointe.

2. Galette en semiconducteur à revêtement épitaxial selon la revendication 1, laquelle possède des germes de BMD qui peuvent se développer en BMD dont la densité à une distance de 50 µm de la surface polie de la couche épitaxiale n'est pas supérieure à 70 % de la densité de pointe.

3. Procédé de fabrication d'une galette en semiconducteur à revêtement épitaxial, comprenant la fourniture d'une galette de substrat en silicium monocristallin ayant un côté avant et ayant un côté arrière ;
le dépôt d'une couche épitaxiale en silicium sur le côté avant de la galette de substrat ;
le traitement de la couche épitaxiale avec un agent oxydant ;
un traitement RTA de la galette en semiconducteur à revêtement épitaxial à une température dans une plage de températures d'au moins 1160 °C à au plus 1185 °C pendant une période d'au moins 15 s à au plus 30 s, la couche épitaxiale étant exposée à une atmosphère composée d'argon et d'ammoniac et une couche d'oxynitrure se formant sur la couche épitaxiale, le côté arrière de la galette de substrat étant exposée pendant le traitement RTA à une atmosphère qui n'a pas ou à peine un effet nitrurant à la température du traitement RTA ;
l'enlèvement de la couche d'oxynitrure ; et
le polissage de la couche épitaxiale.

4. Procédé selon la revendication 3, **caractérisé en ce que** la couche d'oxynitrure est enlevée avec un agent corrosif aqueux qui contient au moins 0,8 % et au plus 2,0 % de fluorure d'hydrogène.
